# EUROPEAN PATENT APPLICATION

(11) **EP 2 701 466 A1**
(43) Date of publication of application: **26.02.2014**
(21) Application number: 12863567.9
(22) Date of filing: 10.12.2012
(51) Int. Cl.: H05B 33/10, C23C 14/24, H01L 51/50

(54) **METHOD AND DEVICE FOR PRODUCING ORGANIC EL ELEMENT**

(30) Priority: 27.12.2011 JP 2011285565
(71) Applicant: Nitto Denko Corporation, Osaka 567-8680 (JP)
(72) Inventor: KAKIUCHI, Ryohei, Osaka 567-8680 (JP); YAMAMOTO, Satoru, Osaka 567-8680 (JP); HIDA, Kanako, Osaka 567-8680 (JP)
(74) Representative: Stolmár & Partner
(86) International application number: PCT/JP2012/081976
(87) International publication number: WO 2013/099579

(57) **Abstract**

Provided are a method and an apparatus for manufacturing an organic EL device which enable deposition of a vaporized material onto a substrate in a desired pattern, while eliminating the need for a conventional strip-shaped shadow mask. A shielding portion is configured to be switchable between a shield position where the shielding portion is arranged between an evaporation source and a substrate so as to shield the substrate and a shield release position where the shielding portion is withdrawn from between the evaporation source and the substrate so as to release the shielding of the substrate. The shielding portion is moved in a transportation direction at the same speed as the substrate when the shielding portion is located at the shield position, whereas the shielding portion is moved in a direction opposite to the transportation direction when the shielding portion is located at the shield release position.

## Description

### FIELD OF THE INVENTION

The present invention relates to a method for manufacturing an organic EL (electroluminescence) device formed by deposition of a vaporized material from an evaporation source onto a substrate having a strip shape. The present invention relates also to an apparatus for manufacturing the organic EL device.

### BACKGROUND ART

Conventionally, a manufacturing method that includes the steps of: transporting a substrate having a strip shape so that the substrate is transported along a predetermined transportation direction; and depositing a vaporized material discharged from an evaporation source onto the substrate is known as a method for manufacturing an organic EL device (see, for example, Patent Literature 1). According to such a manufacturing method, a strip-shaped shadow mask is brought into surface-to-surface close contact with the substrate having a strip shape, and the shadow mask is transported integrally with the substrate, thereby depositing the vaporized material onto the substrate in a desired pattern.

### CITATION LIST

Patent Literature 1: JP 2000-183500 A

### SUMMARY OF INVENTION

### Technical Problem

In the manufacturing method according to Patent Literature 1, a feed-out roller that feeds out the shadow mask, a take-up roller that winds up the shadow mask, and a plurality of support rollers that support the shadow mask are provided in an apparatus. With this regard, there is generally a problem of an increase in size of the apparatus. Further, in the case of deposition of the vaporized material onto the substrate in a different pattern, there is a need for complex operation to replace the shadow mask with another one (pattern switching), which is a problem.

In view of such circumstances, it is an object of the present invention to provide a method and an apparatus for manufacturing an organic EL device which allow deposition of a vaporized material from an evaporation source onto a substrate in a desired pattern, while eliminating the need for such a conventional strip-shaped shadow mask.

### Solution to Problem

According to the present invention, there is provided a method for manufacturing an organic EL device, which includes the steps of: transporting a substrate having a strip shape so that the substrate is transported along a predetermined transportation direction; depositing a vaporized material onto a predetermined part of the substrate by discharging the vaporized material from an evaporation source; and arranging a shielding portion for shielding the substrate between the evaporation source and the substrate so as to prevent the deposition of the vaporized material onto the part other than the predetermined part during the deposition of the vaporized material, wherein the shielding portion is switchable between a shield position where the shielding portion is arranged between the evaporation source and the substrate so as to shield the substrate and a shield release position where the shielding portion is withdrawn from between the evaporation source and the substrate so as to release the shielding of the substrate, and wherein the shielding portion is moved in the predetermined transportation direction at the same speed as the substrate when the shielding portion is located at the shield position whereas the shielding portion is moved in a direction opposite to the predetermined transportation direction when the shielding portion is located at the shield release position.

In the method for manufacturing an organic EL device according to the present invention, the shielding portion may have a larger dimension than the width dimension of the substrate so as to be arranged across the width direction of the substrate when being located at the shield position.

Further, in the method for manufacturing an organic EL device according to the present invention, the shielding portion is desirably a flip-type shield plate.

According to the present invention, there is also provided an apparatus for manufacturing an organic EL device, which includes: a transporting unit for transporting a substrate having a strip shape along a predetermined transportation direction; an evaporation source for discharging a vaporized material toward a predetermined part of the substrate so that the vaporized material is deposited onto the substrate; a shielding unit including a shielding portion for shielding the substrate so as to prevent deposition of the vaporized material onto the part other than the predetermined part; and a moving unit for moving the shielding portion, wherein the shielding unit includes a switching mechanism capable of switching the shielding portion between a shield position where the shielding portion is arranged between the evaporation source and the substrate so as to shield the substrate and a shield release position where the shielding portion is withdrawn from between the evaporation source and the substrate so as to release the shielding of the substrate, and wherein the moving unit moves the shielding portion in the predetermined transportation direction at the same speed as the substrate when the shielding portion is located at the shield position, whereas the moving unit moves the shielding portion in a direction opposite to the predetermined transportation direction when the shielding portion is located at the shield release position.

### Advantageous Effects of Invention

As described above, the present invention exerts an excellent effect that enable deposition of a vaporized material from an evaporation source onto a substrate in a desired pattern, while eliminating the need for a conventional strip-shaped shadow mask.

### BRIEF DESCRIPTION OF DRAWINGS

FIG. 1 is a schematic front view showing an apparatus for manufacturing an organic EL device according to one embodiment of the present invention.
FIG. 2 is a plan view of a main part of the apparatus for manufacturing an organic EL device according to the one embodiment.
FIG. 3 is a side view of a main part of the apparatus for manufacturing an organic EL device according to the one embodiment.
FIG. 4 is a side view of a main part of the apparatus for manufacturing an organic EL device according to the one embodiment when a shielding portion is located at a shield release position.
FIG. 5 is a front view of a main part of the apparatus for manufacturing an organic EL device according to the one embodiment when the shielding portion is located at the shield release position.
FIG. 6 is a side view of a main part of the apparatus for manufacturing an organic EL device according to the one embodiment when the shielding portion is located at the shield position.
FIG. 7 is a front view of a main part of the apparatus for manufacturing an organic EL device according to the one embodiment when the shielding portion is located at the shield position.
FIG. 8 is a plan view of a main part for explanation of a method for manufacturing an organic EL device according to the one embodiment.
FIG. 9 is a plan view of a main part for explanation of the method for manufacturing an organic EL device according to the one embodiment.
FIG. 10 is a plan view of a main part for explanation of the method for manufacturing an organic EL device according to the one embodiment.
FIG. 11 is a plan view of a main part for explanation of the method for manufacturing an organic EL device according to the one embodiment.
FIG. 12 is a plan view of a main part of an organic EL device manufactured by the manufacturing method according to the one embodiment.
FIG. 13 is an enlarged sectional view taken along the line XIII-XIII of FIG. 12 that shows the organic EL device manufactured by the manufacturing method according to the one embodiment.
FIG. 14 is an enlarged sectional view taken along the line XIV-XIV of FIG. 12 that shows the organic EL device manufactured by the manufacturing method according to the one embodiment.
FIG. 15 is a plan view of a main part of an apparatus for manufacturing an organic EL device according to another embodiment of the present invention.
FIG. 16 is a plan view of a main part of an apparatus for manufacturing an organic EL device according to still another embodiment of the present invention.
FIG. 17 is a plan view of a main part of an apparatus for manufacturing an organic EL device according to still another embodiment of the present invention.
FIG. 18 is a plan view of a main part of an apparatus for manufacturing an organic EL device according to still another embodiment of the present invention.
FIG. 19 is a graph demonstrating the effects of Examples and Comparative Examples of an organic EL device.
FIG. 20 is a partial planar image of Examples of the organic EL device according to the present invention.
FIG. 21 is a partial planar image of Comparative Examples of the organic EL device.
FIG. 22 is a graph showing a cross-sectional profile of an organic EL device.

### DESCRIPTION OF EMBODIMENTS

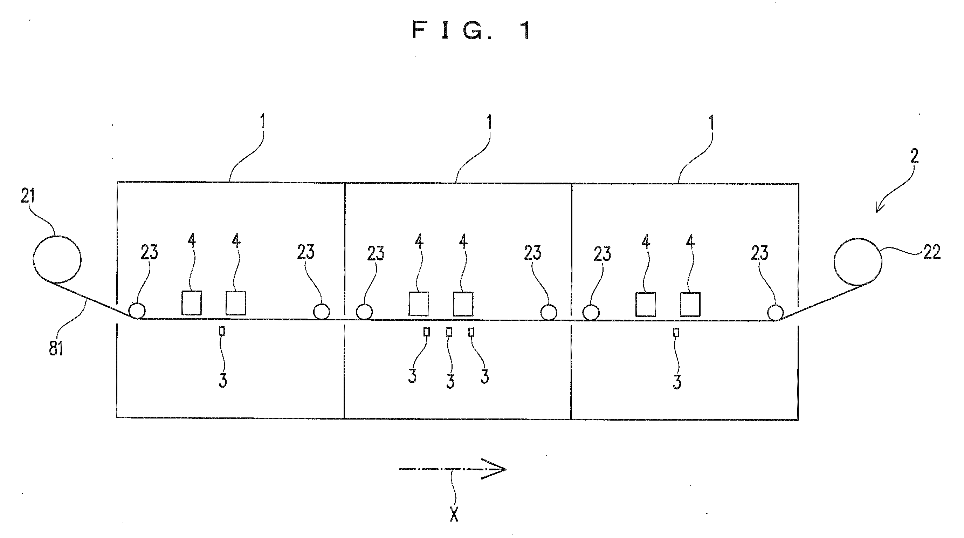

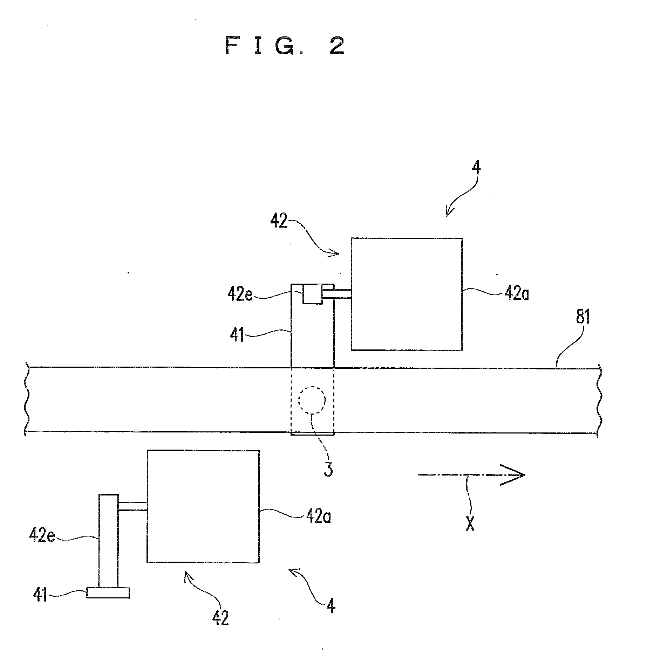

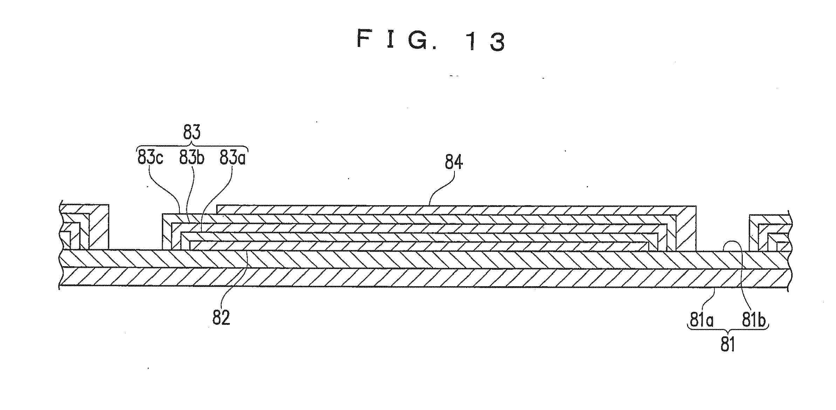

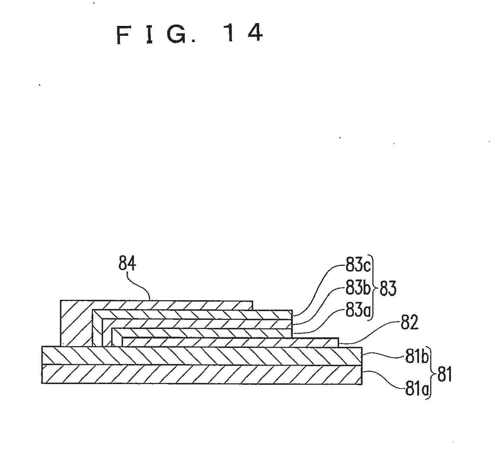

Hereinafter, the apparatus for manufacturing an organic EL according to one embodiment of the present invention (hereinafter, simply referred to also as the "manufacturing apparatus") is described with reference to FIGS. 1 to 14.

As shown in FIGS. 1 to 7, the manufacturing apparatus according to this embodiment includes: a plurality of vacuum chambers 1 inside of which are in a vacuum state; a transporting unit 2 that transports a substrate 81 having a strip shape along the horizontal direction (hereinafter referred to also as a "transportation direction") X so that the substrate 81 passes through the inside of the vacuum chambers 1; and a plurality of evaporation sources 3 that discharge a vaporized material toward the substrate 81 so that the vaporized material is deposited onto the substrate 81. The manufacturing apparatus also includes a plurality of shielding units 4 each having a shielding portion 41 that shields the substrate 81 and a plurality of moving units 5 that each reciprocatingly move the shielding portion 41 along the transportation direction X.

Three vacuum chambers 1 are provided herein. The plurality of vacuum chambers 1 are provided in series along the transportation direction X. Further, each of the vacuum chambers 1 is connected to a vacuum generating unit such as a vacuum pump (not shown or numbered) so that the inside of the vacuum chamber 1 is brought into a vacuum state.

The transporting unit 2 includes a feed-out roller 21 that feeds out the substrate 81, a take-up roller 22 that winds up the substrate 81 (specifically, an organic EL device 8 formed by deposition of the vaporized material onto the substrate 81), and a plurality of support rollers 23 that are arranged between the feed-out roller 21 and the take-up roller 22 and that support the substrate 81. The transporting unit 2 transports the substrate 81 so that the substrate 81 has a portion that extends linearly along the transportation direction X.

The feed-out roller 21 is arranged outside the vacuum chambers 1 on the upstream side thereof. The take-up roller 22 is arranged outside the vacuum chambers 1 on the downstream side thereof. Further, the plurality of support rollers 23 are arranged inside the vacuum chambers 1. The plurality of support rollers 23 are aligned along the transportation direction X. The plurality of support rollers 23 are hung with the substrate 81 and support the upper surface of the substrate 81.

The evaporation sources 3 are respectively arranged inside the vacuum chambers 1. The respective evaporation sources 3 are arranged so as to face the substrate 81 in the up-down direction (vertical direction). Specifically, the respective evaporation sources 3 are arranged on the lower side of the substrate 81. The respective evaporation sources 3 are arranged so as to face the lower surface of the substrate 81. One of the evaporation sources 3 is provided in each of the upstream and downstream vacuum chambers 1. Three of the evaporation sources 3 are provided in the middle vacuum chamber 1, aligned along the transportation direction X in the vacuum chamber 1.

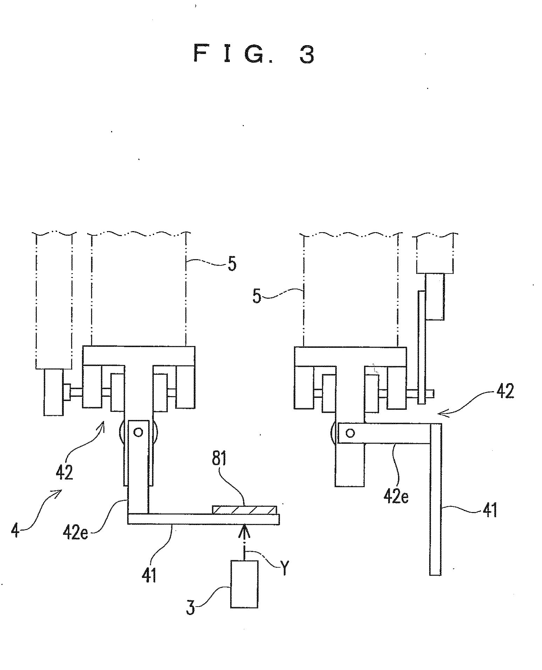

Each evaporation source 3 discharges a vaporized material that has been vaporized by heating toward the substrate 81. Specifically, the evaporation source 3 discharges the vaporized material in the upward direction (direction of the arrow Y in FIGS. 3 to 7).

Each shielding unit 4 includes a switching mechanism 42 that switches the position of the shielding portion 41 by rotationally moving the shielding portion 41. The shielding unit 4 is configured to be switchable by the switching mechanism 42 between a shield position where the shielding portion 41 is arranged between each evaporation source 3 and the substrate 81 so as to shield the substrate 81 and a shield release position where the shielding portion 41 is withdrawn from between the evaporation source 3 and the substrate 81 so as to release the shielding of the substrate 81.

A pair of shielding units 4 are provided inside each of the vacuum chambers 1. The pair of shielding units 4 are arranged on the respective lateral sides of the substrate 81. Specifically, the pair of shielding units 4 are arranged so as to face each other with the substrate 81 interposed therebetween in the width direction.

Each shielding portion 41 serves not only to allow deposition of a specific vaporized material discharged from the corresponding evaporation source 3 onto a predetermined part over which an organic EL device is intended to be formed, but also to shield the part other than the predetermined part so as to prevent deposition of the vaporized material thereon. Here, "the part other than the predetermined part" denotes the part of the substrate 81 that overlaps the shielding portion 41, when seen in a direction facing the evaporation source 3, at the position where the shielding portion 41 is overlapped by the substrate 81 for shielding.

The shielding portion 41 is formed into a plate in a strip shape or a rectangular shape. More specifically, a so-called flip-type shield plate is employed as the shielding portion 41 in this embodiment. The flip-type shield plate is of the type that rotates the shielding portion 41 around the transportation direction X (horizontal direction) so that the upper surface of the shielding portion 41 moves toward and away from the lower surface of the substrate, particularly at the closest position to the substrate 81.

In addition to the flip-type shield plate, a so-called slide-type shield plate that rotates the shielding portion 41 around a direction orthogonal to the transportation direction X (vertical direction) so that the upper surface of the shielding portion 41 moves along the lower surface of the substrate, particularly at the closest position to the substrate 81. The shielding portion 41 has a larger dimension in the longitudinal direction than the width dimension of the substrate 41 so as to be arranged across the width direction of the substrate 81 when being located at the shield position.

The shielding portion 41 when being located at the shield position is arranged at a distance from the substrate 81. The distance between the shielding portion 41 and the substrate 81 is desirably 1 mm or less, for example. It is also possible to arrange the shielding portion 41 when being located at the shield position so that its upper surface comes in contact with the lower surface of the substrate 81.

Each switching mechanism 42 includes a body 42a that is connected to each moving unit 5 so as to be moved by the moving unit 5. The switching mechanism 42 further includes: a first rotating member 42b that is fixed to the body 42a so as to rotate around a shaft arranged along the width direction of the substrate 81 (direction orthogonal to the transportation direction X); and a second rotating member 42c that is fixed to the body 42a so as to rotate around a shaft arranged along the transportation direction X and that is driven by the first rotating member 42b.

The switching mechanism 42 includes: a first linking member 42d having one end portion coupled to the shaft of the first rotating member 42b; and a second linking member 42e having one end portion coupled to the shaft of the second rotating member 42c and the other end portion coupled to the end portion of the shielding portion 41. The switching mechanism 42 further includes: a cam follower 42f that is rotatably attached to the other end portion of the first linking member 42d; and a cam 42g that is in sliding contact with the cam follower 42f.

A magnetic body is provided inside each of the first rotating member 42b and the second rotating member 42c. This causes the second rotating member 42c to rotate with the rotation of the first rotating member 42b because the magnetic body of the second rotating member 42c receives a magnetic force from the magnetic body of the first rotating member 42b. The first rotating member 42b and the second rotating member 42c are arranged at a distance from each other.

Each cam 42g has an elongated shape extending along the transportation direction X. The lower surface of the cam 42g is in sliding contact with the outer circumferential surface of the cam follower 42f. The cam 42g is configured to be displaceable in the up-down direction (vertical direction).

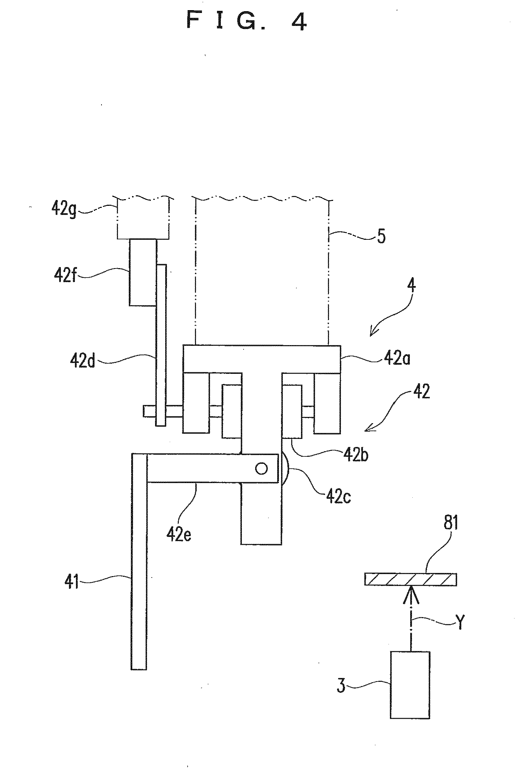

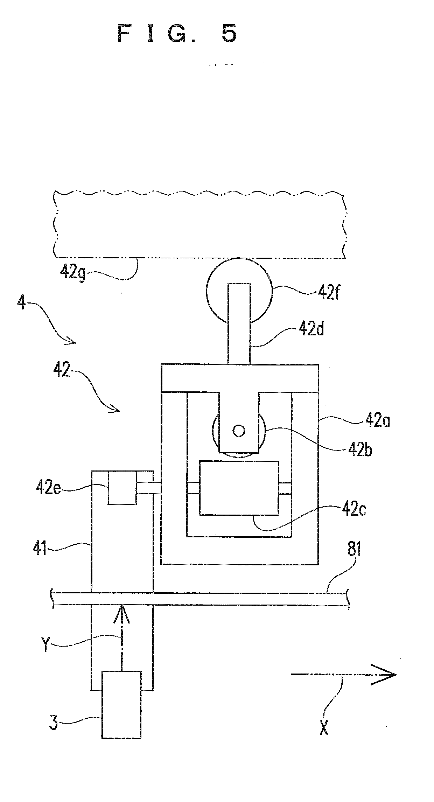

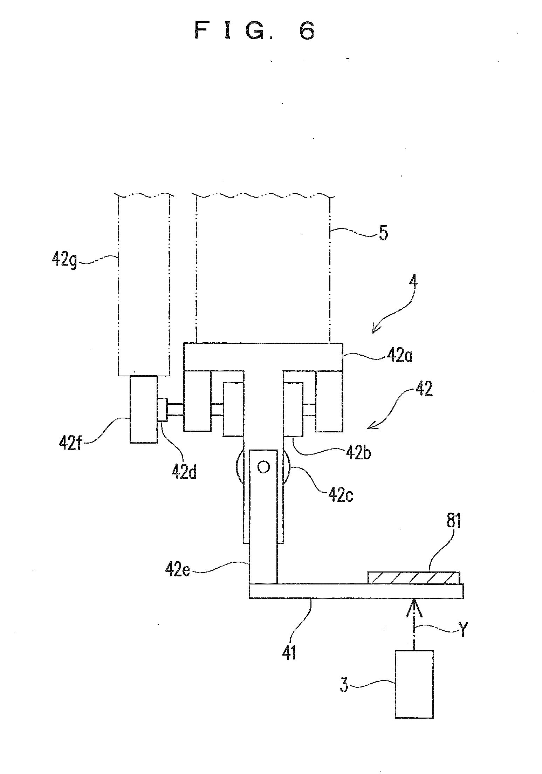

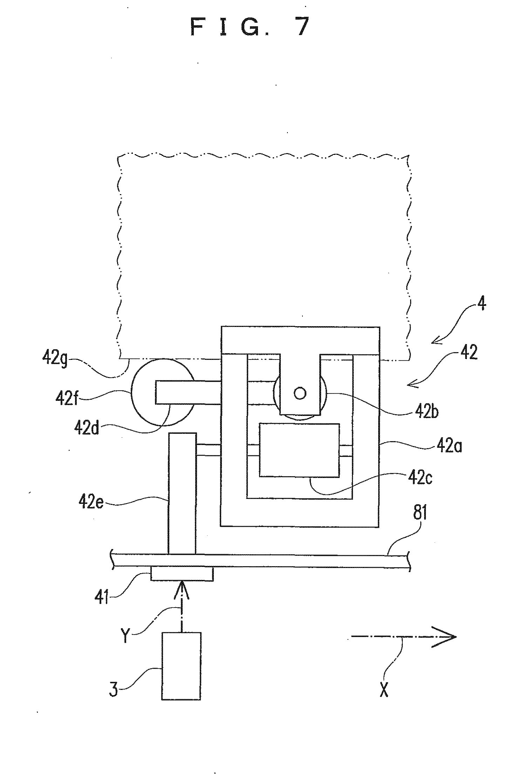

Each switching mechanism 42 includes a biasing unit (not shown or numbered) by which the cam follower 42f is biased so as to be displaced upward. Accordingly, the switching mechanism 42 is configured to allow the shielding portion 41 to be located at the shield release position by placing the cam 42g on the upper side (see FIG. 4 and FIG. 5), while allowing the shielding portion 41 to be located at the shield position by placing the cam 42g on the lower side (see FIG. 6 and FIG. 7).

The moving unit 5 is arranged on the upper side of each shielding unit 4 inside the corresponding vacuum chamber 1. Each moving unit 5 is connected to the upper part of the body 42a and reciprocatingly moves the body 42a along the transportation direction X, thereby allowing the shielding portion 41 to move reciprocatingly along the transportation direction X. Specifically, the moving unit 5 moves the shielding portion 41 which is located at the shield position in the transportation direction X at the same speed as the substrate 81, while moving the shielding portion 41 which is located at the shield release position in a direction opposite to the transportation direction X.

The configuration of the apparatus for manufacturing an organic EL device according to this embodiment has been described above. Next, the method for manufacturing an organic EL device according to this embodiment is described.

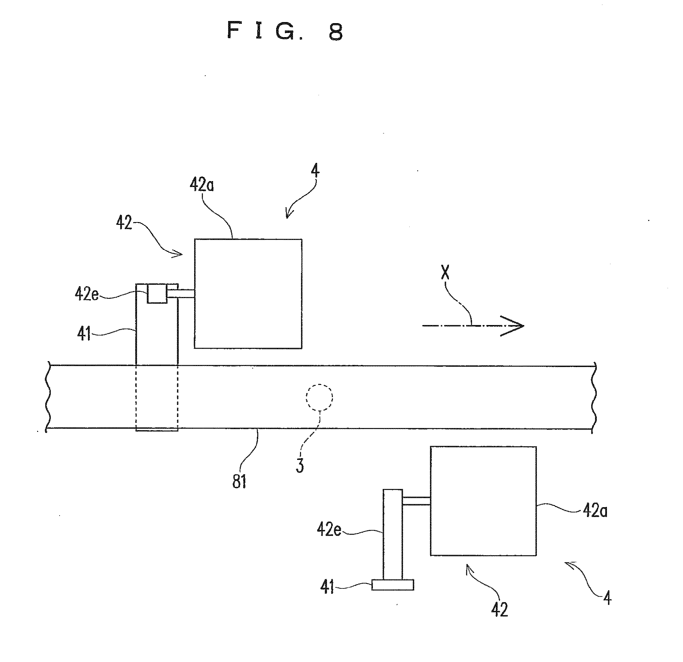

The transporting unit 2 transports the substrate 81, thereby keeping the substrate 81 running along the transportation direction X. Each evaporation source 3 discharges the vaporized material toward the substrate 81 that is running, so that the vaporized material is deposited onto the substrate 81. During this time, the shielding portion 41 is maintained at the shield position. This prevents deposition of the vaporized material onto the part other than a predetermined part on which the vaporized material is supposed to be deposited in the substrate 81 shielded by the shielding portion 41. Such action is described below in detail with reference to FIGS. 8 to 11.

One of the pair of shielding units 4 on one side (upper side in FIGS. 8 to 11) is described. First, when the cam 42g is located on the lower side, the shielding portion 41 is located at the shield position so as to shield the lower surface of the substrate 81, as shown in FIG. 8. Then, the body 42a is moved in the transportation direction X by the moving unit 5 at the same speed as the substrate 81, thereby moving the shielding portion 41 in the transportation direction X at the same speed as the substrate 81.

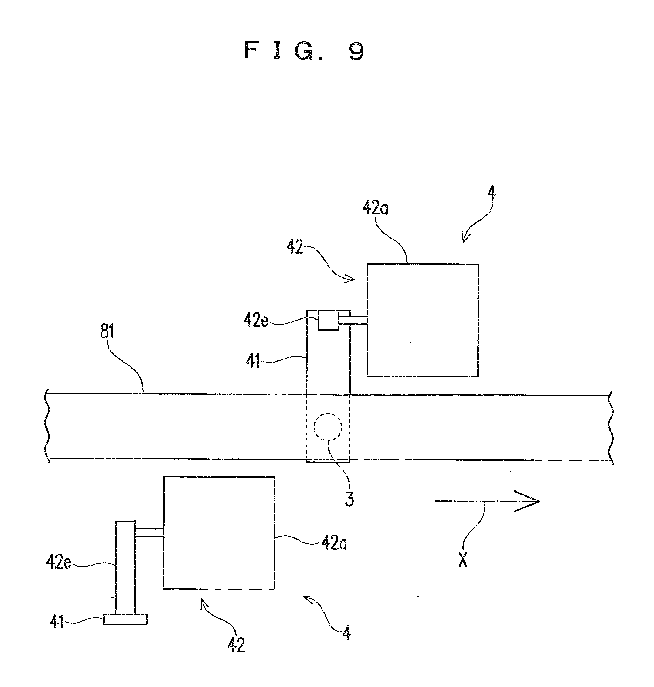

At this time, since the cam follower 42f is in sliding contact with the cam 42g located on the lower side, the shielding portion 41 is interposed between the evaporation source 3 and the substrate 81, when the shielding portion 41 is moved in the transportation direction X, so that the shielding portion 41 is maintained at the shield position, as shown in FIG. 9. This prevents deposition of the vaporized material onto the part other than a predetermined part on which the vaporized material is supposed to be deposited in the substrate 81 shielded by the shielding portion 41.

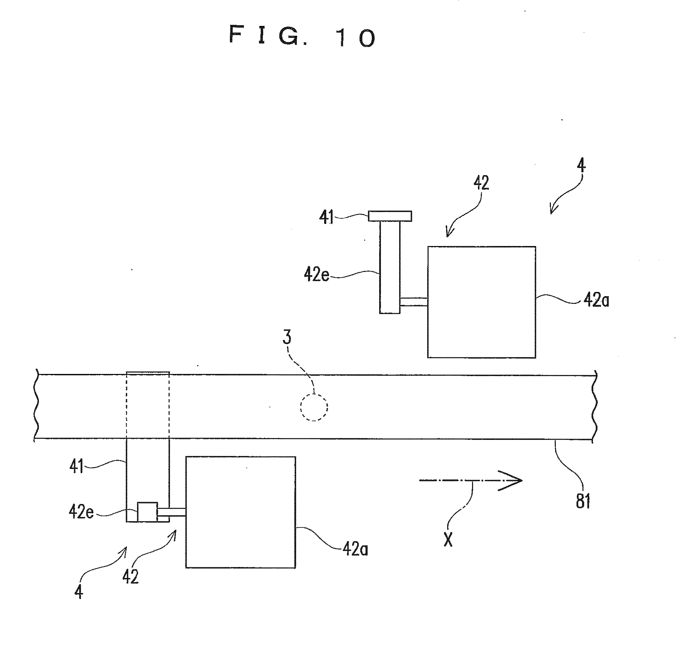

When the body 42a has been moved to the downstream end of the moving range, the cam 42g is displaced to be located on the upper side. Therefore, when the shielding portion 41 is withdrawn from between the evaporation source 3 and the substrate 81, the shielding portion 41 is switched to the shield release position where the shielding portion 41 releases the shielding of the substrate 81, as shown in FIG. 10. Thereafter, the body 42a is moved in a direction opposite to the transportation direction X by the moving unit 5, thereby moving the shielding portion 41 in a direction opposite to the transportation direction X.

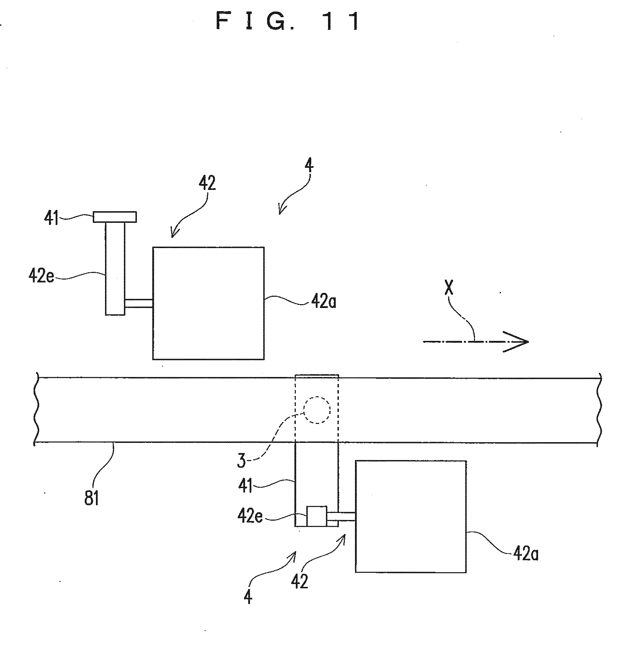

At this time, since the cam follower 42f is in sliding contact with the cam 42g located on the upper side, the shielding portion 41 is maintained at the shield release position, during the time when the shielding portion 41 is moved in a direction opposite to the transportation direction X, as shown in FIG. 11. This makes it possible to return the shielding portion 41 to the upstream end of the moving range, without preventing the deposition of the vaporized material discharged from the evaporation source 3 onto the substrate 81.

When the cam 42g is displaced to be located on the lower side, the shielding portion 41 is located at the shield position so as to shield the lower surface of the substrate 81, and the body 42a is moved by the moving unit 5 in the transportation direction X at the same speed as the substrate 81, thereby moving the shielding portion 41 in the transportation direction X at the same speed as the substrate 81, as shown in FIG. 8.

As shown in FIGS. 8 to 11, during the time when the shielding unit 4 on one side has the shielding portion 41 located at the shield position and is moved in the transportation direction X, the shielding unit 4 on the other side (lower side in FIGS. 8 to 11) has the shielding portion 41 located at the shield release position and is moved in a direction opposite to the transportation direction X. Meanwhile, during the time when the shielding unit 4 on one side has the shielding portion 41 located at the shield release position and is moved in a direction opposite to the transportation direction X, the shielding unit 4 on the other side has the shielding portion 41 located at the shield position and is moved in the transportation direction X.

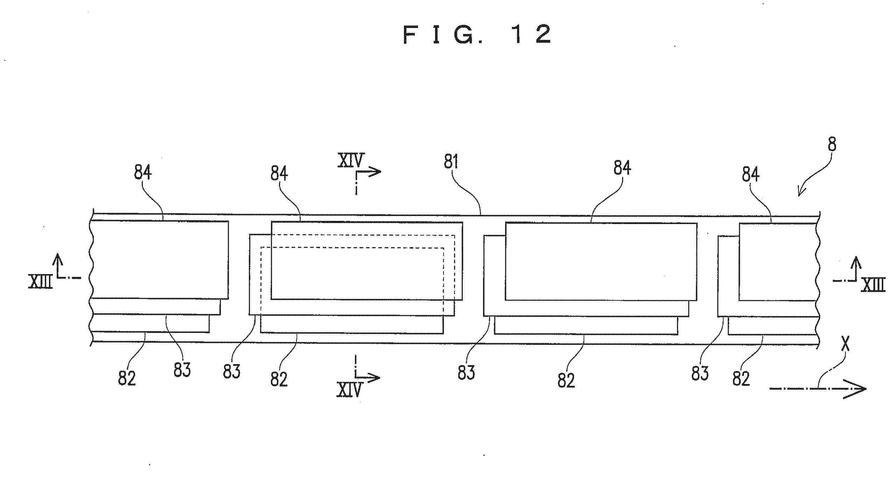

In this way, organic EL devices 8 can be produced continuously by repeating the reciprocating actions of the respective shielding units 4. Such an organic EL device 8 is described below in detail with reference to FIGS. 12 to 14.

As shown in FIGS. 12 to 14, the organic EL device 8 includes: a lower electrode layer 82 formed by deposition of the vaporized material from the evaporation source 4 onto a surface on one side of the substrate 81 an organic layer 83 formed by deposition of the vaporized material over the lower electrode layer 82; and an upper electrode layer 84 formed by deposition of the vaporized material over the organic layer 83. The organic EL device 8 includes a part on which no vaporized material is deposited, that is, a part provided without the respective layers 82, 83, and 84, across the width direction of the substrate 81.

The substrate 81 includes: a conductive layer 81a having a conductivity; and an insulation layer 81b having an insulating property. The conductive layer 81a is composed of a metal substrate. The conductive layer 81a is formed, for example, of a metal such as stainless steel, copper, and nickel. Further, the insulation layer 81b is arranged so as to cover the entire surface on one side of the conductive layer 81a. The insulation layer 81b is formed, for example, of thin glass or a photocurable resin such as polyimide resin, polyester resin, and epoxy resin.

The lower electrode layer 82 is arranged so that at least a part thereof is not covered by the organic layer 83 and the upper electrode layer 84 so as to be exposed. The lower electrode layer 82 serves as an anode layer in this embodiment. The lower electrode layer 82 is formed, for example, of a transparent conductive material such as indium-zinc oxide (IZO) and indium-tin oxide (ITO), or a metal such as gold, silver, and aluminum.

The organic layer 83 includes: a hole injection layer 83a disposed on the lower electrode layer 82; an organic EL layer 83b disposed on the hole injection layer 83a; and an electron injection layer 83c disposed on the organic EL layer 83b. The organic layer 83 is disposed between the lower electrode layer 82 and the upper electrode layer 84 so as to prevent contact between the lower electrode layer 82 and the upper electrode layer 84.

The hole injection layer 83a is formed, for example, of copper phthalocyanine (CuPc) or 4,4'- bis[N-4-(N, N-di-m-tolylamino)phenyl]-N-phenylamino]biphenyl (DNTPD). Further, the organic EL layer 83b is formed, for example, of tris (8-hydroxyquinoline) aluminum (Alq3) or 4,4'-N,N'-dicarbazolyl biphenyl (CBP) doped with an iridium complex (Ir(ppy)3). Further, the electron injection layer 83c is formed, for example, of lithium fluoride (LiF), cesium fluoride (CsF), or lithium oxide (Li₂O).

The upper electrode layer 84 serves as a cathode layer in this embodiment. The upper electrode layer 84 is formed, for example, of aluminum, silver, magnesium silver alloy, or an alloy containing alkali metal or alkaline earth metal.

Accordingly, the evaporation source 3 arranged in the vacuum chamber 1 on the upstream side discharges the vaporized material that forms the lower electrode layer 82. The evaporation sources 3 arranged in the vacuum chamber 1 in the middle respectively discharge, from the upstream side, the vaporized material that forms the hole injection layer 83a, the vaporized material that forms the organic EL layer 83b, and the vaporized material that forms the electron injection layer 83c. The evaporation source 3 arranged in the vacuum chamber 1 on the downstream side discharges the vaporized material that forms the upper electrode layer 84.

As described above, in the method and the apparatus for manufacturing an organic EL device according to this embodiment, the shielding portion 41 is located at the shield position so as to shield the substrate 81 by being arranged between the corresponding evaporation source 3 and the substrate 81. Then, the shielding portion 41 is moved from the upstream side of the evaporation source 3 in the transportation direction X at the same speed as the substrate 81 while the shielding portion 41 is maintained at the shield position. This can prevent deposition of the vaporized material onto the part other than a predetermined part, while depositing the vaporized material onto the predetermined part.

Further, when the shielding portion 41 has been moved toward the downstream side of the evaporation source 3 and has reached the downstream end (termination point) of the moving range, the shielding portion 41 is withdrawn from between the evaporation source 3 and the substrate 81, and thereby the shielding portion 41 is switched to the shield release position so as to release the shielding of the substrate 81. Then, the shielding portion 41 is moved in a direction opposite to the transportation direction X while being maintained at the shield release position.

This makes it possible to return the shielding portion 41 to the upstream end (start point) of the moving range, without preventing deposition of the vaporized material discharged from the evaporation source 3 onto a substrate X that is being transported. Organic EL devices 8 can be produced continuously by repeating such actions. Accordingly, the vaporized material from the evaporation source 3 can be deposited onto the substrate 81 in a desired pattern, while eliminating the need for such a strip-shaped shadow mask as conventionally required.

Further, in the method and the apparatus for manufacturing an organic EL device according to this embodiment, the shielding portion 41 has a larger dimension than the width dimension of the substrate 81, so that the shielding portion 41 is arranged across the width direction of the substrate 81 when being located at the shield position. This allows a part onto which no vaporized material is deposited to be formed across the width direction of the substrate 81. Therefore, cutting of the organic EL device can be performed along such a part in a subsequent step.

Further, in the method and the apparatus for manufacturing an organic EL device according to this embodiment, use of a flip-type shield plate as the shielding portion 41 enables its position to be securely switched between the shield position and the shield release position.

It should be noted that the method and the apparatus for manufacturing an organic EL device according to the present invention are not limited to those having the configurations of the above-mentioned embodiments. The method and the apparatus for manufacturing an organic EL device according to the present invention are not limited also to those having the aforementioned effects. The method and the apparatus for manufacturing an organic EL device according to the present invention can be variously modified without departing from the gist of the present invention.

For example, the method and the apparatus for manufacturing an organic EL device according to the above-mentioned embodiment described herein has a configuration in which the shielding portion 41 is formed into a strip shape or a rectangular shape, which however is not restrictive.

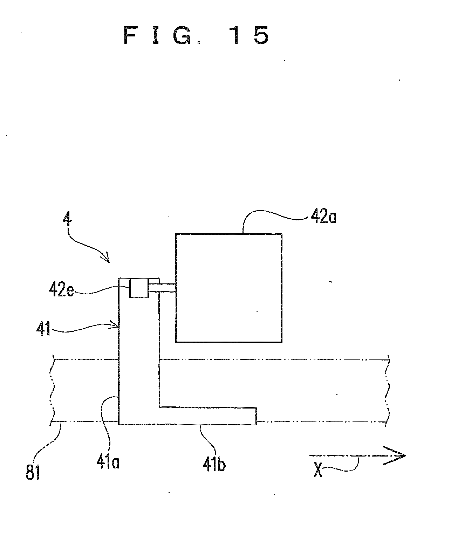

Specifically, as shown in FIG. 15, the shielding portion 41 may be configured to have: a first shielding portion 41a provided substantially orthogonal to the longitudinal direction of the substrate 81; and a second shielding portion 41b provided substantially orthogonal to the first shielding portion 41a.

As shown in FIG. 15, the first shielding portion 41a is configured to have a strip shape or a rectangular shape. The first shielding portion 41a has one end portion coupled to the second linking member 42e of the switching mechanism 42 and the other end portion formed integrally with the second shielding portion 41b. The second shielding portion 41b is configured to have a strip shape or a rectangular shape. The second shielding portion 41b is provided along the longitudinal direction of the substrate 81, while overlapping one end portion in the width direction of the substrate 81.

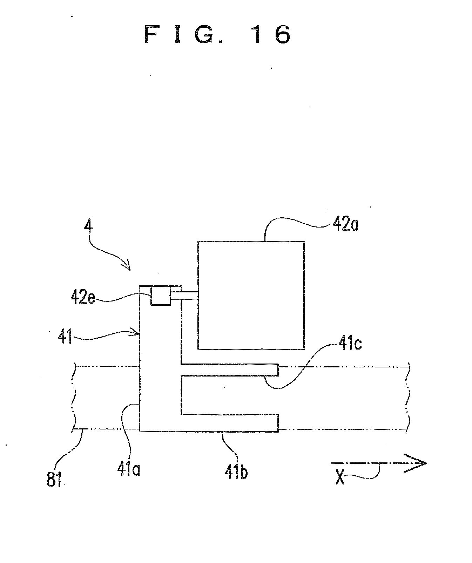

As shown in FIG. 16, the shielding portion 41 may be configured to have a third shielding portion 41c, in addition to the first shielding portion 41a and the second shielding portion 41b shown in FIG. 15. The third shielding portion 41c is configured to have a strip shape or a rectangular shape. The third shielding portion 41c is formed to project from an intermediate portion of the first shielding portion 41a so as to be substantially orthogonal to the first shielding portion 41a.

While the second shielding portion 41b is provided so as to overlap the one end portion in the width direction of the substrate 81, the third shielding portion 41c is provided so as to overlap the other end portion on the opposite side in the width direction of the substrate 81. Further, the third shielding portion 41c is substantially in parallel to the second shielding portion 41b. Furthermore, the third shielding portion 41c is provided along the longitudinal direction of the substrate 81.

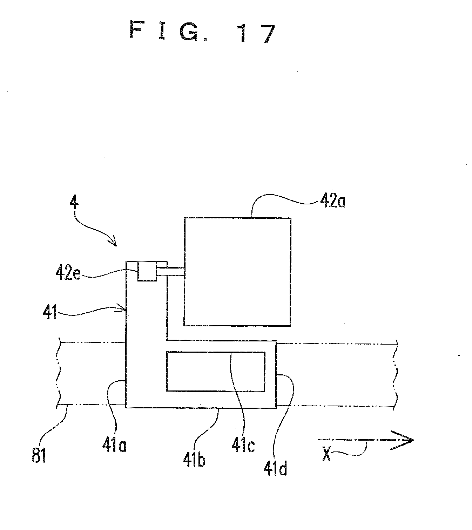

Alternatively, the shielding portion 41 may be configured to have a fourth shielding portion 41d, as shown in FIG. 17, in addition to the first shielding portion 41a, the second shielding portion 41b, and the third shielding portion 41c shown in FIG. 16. The fourth shielding portion 41d is configured to have a strip shape or a rectangular shape. The fourth shielding portion 41d couples an end portion of the second shielding portion 41b and an end portion of the third shielding portion 41c to each other. Further, the fourth shielding portion 41d is substantially in parallel to the first shielding portion 41a. Furthermore, the fourth shielding portion 41d is provided along the width direction of the substrate 8.

With such a configuration as mentioned above, the shielding portion 41 shown in FIG. 17 is composed of the first shielding portion 41a, the second shielding portion 41b, the third shielding portion 41c, and the fourth shielding portion 41d, so as to have a quadrangular shape. The shielding portion 41 has one opening surrounded by the first shielding portion 41a to the fourth shielding portion 41d.

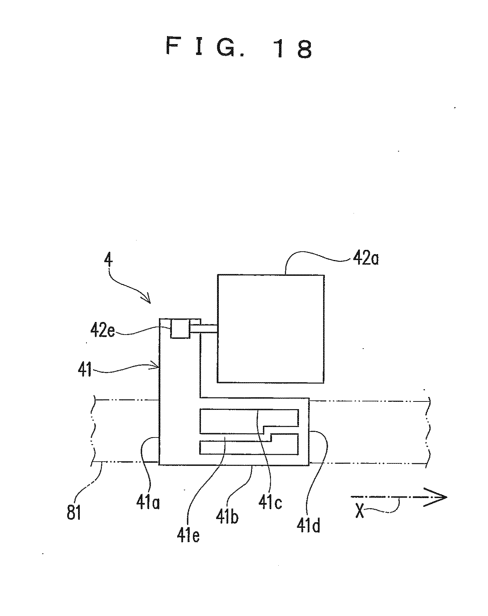

Alternatively, the shielding portion 41 may be configured to have a fifth shielding portion 41e, as shown in FIG. 18, in addition to the first shielding portion 41a to the fourth shielding portion 41d shown in FIG. 17. The fifth shielding portion 41e is configured to have a strip shape with its intermediate portion being bent. The fifth shielding portion 41e is provided between the second shielding portion 41b and the third shielding portion 41c.

The fifth shielding portion 41e couples an intermediate portion of the first shielding portion 41a and an intermediate portion of the fourth shielding portion 41d to each other. The fifth shielding portion 41e is provided so as to be substantially orthogonal to the first shielding portion 41a and the fourth shielding portion 41d. Further, the fifth shielding portion 41e is provided along the longitudinal direction of the substrate 81. With such a configuration as mentioned above, the shielding portion 41 shown in FIG. 18 has two openings defined by the first shielding portion 41a to the fifth shielding portion 41e.

Further, in the method and the apparatus for manufacturing an organic EL device according to the present invention, the switching mechanism 42 is not limited to one having a configuration according to the above-mentioned embodiments, and needs only to have a configuration capable of switching the shielding portion 41 between the shield position and the shield release position.

In the method and the apparatus for manufacturing an organic EL device according to the present invention, the moving unit 5 is not limited to those having the configurations of the above-mentioned embodiments, and needs only to have a configuration that allows reciprocating movement of the shielding portion 41 along the transportation direction X.

### EXAMPLES

Next, the present invention is further described in detail with reference to Examples. However, the present invention is not limited to these Examples.

### (Example 1)

Using a manufacturing apparatus with the following conditions, an anode layer, an organic EL layer, and a cathode layer were formed over a substrate to produce organic EL devices. A material made of SUS304 with a thickness of 0.1 mm was employed as a shielding portion. A vacuum chamber with a degree of vacuum thereinside of 5.0 × 10⁻⁵ Pa was used. A substrate with a width dimension of 50 mm was used. The substrate was conveyed at a speed of 1 m/min. A material made of SUS304 with a thickness of 50 µm was employed as the substrate. An insulation layer with a thickness of 4 µm was formed over the substrate on the organic EL device side.

The organic EL devices produced with the above-mentioned conditions were cut out with scissors along the width direction of the substrate at the center between each adjacent organic EL devices in the longitudinal direction of the substrate, thereby separating the organic EL devices from each other. Then, a voltage was applied to the anode layer and the cathode layer of each organic EL device, as a result of which green light emission in an area with a length of 314 mm in the longitudinal direction of the substrate and a length of 38 mm in the width direction of the substrate was observed from every organic EL device. The light emission within that area was uniform. Further, no flaws such as short-out were observed in the organic EL devices. In Example 1, ten organic EL devices were produced, and desired light emission was achieved in all the devices.

### (Comparative Example)

Organic EL devices as Comparative Example were produced by a manufacturing apparatus that uses a strip-shaped shadow mask instead of using the shielding unit of Example 1. The strip-shaped shadow mask is wound around a shadow mask-unwinding roller. The strip-shaped shadow mask unwound from the shadow mask-unwinding roller is supplied between a substrate and an evaporation source, and then wound up by a shadow mask-winding roller. The shadow mask has openings formed at a specific pitch. The shadow mask thus unwound is brought into close contact with the substrate by a pressure roller.

Using such a manufacturing apparatus provided with the strip-shaped shadow mask, an organic EL layer and a cathode layer were formed over an anode layer that had been formed over the substrate, in the same manner as in Example 1. As a result, the shadow mask and the anode layer formed over the substrate were rubbed against each other, and thus the anode layer was damaged. More specifically, one among the produced ten organic EL devices had a damage on its anode layer. Further, a positional displacement occurred between the respective openings of the strip-shaped shadow mask and the anode layer in the course of continuous film formation, after which it was impossible to produce organic EL devices with desired quality.

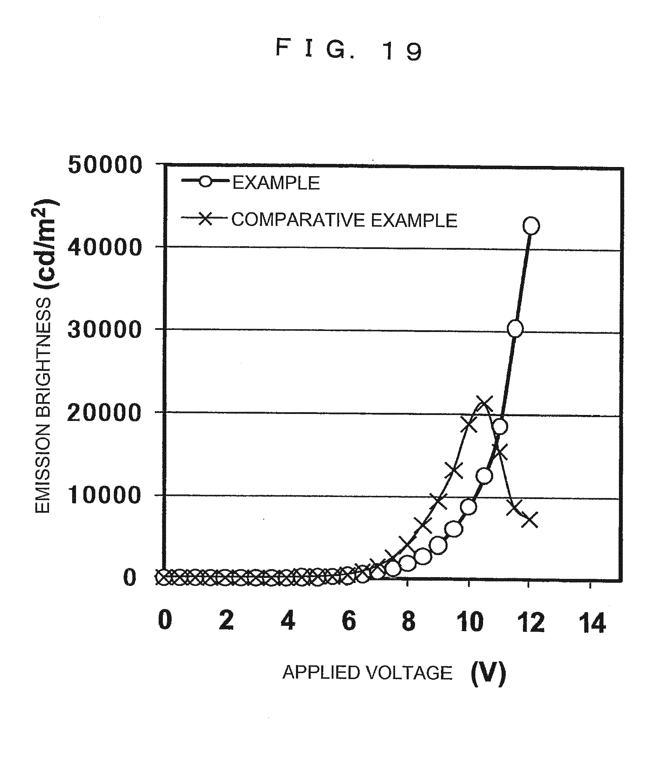

The present inventors conducted a performance test for the organic EL device according to the above-mentioned Example 1 and the organic EL device according to Comparative Example that had a damage in the anode layer. As a test result, FIG. 19 shows that the emission brightness of the organic EL device according to Example 1 gradually increased after the applied voltage had exceeded about 7 V, and hence exceeded 40000 cd/m² when the applied voltage reached 12 V, where a desired emission brightness was achieved.

In contrast, it was revealed that, in the organic EL device according to Comparative Example which had an operation failure, the emission brightness gradually increased after the applied voltage had exceeded about 7 V, however, to fail to reach the desired emission brightness even when the applied voltage reached 12 V. From these results, it is assumed that Comparative Example failed to exert desired performance because of the damage in the anode layer.

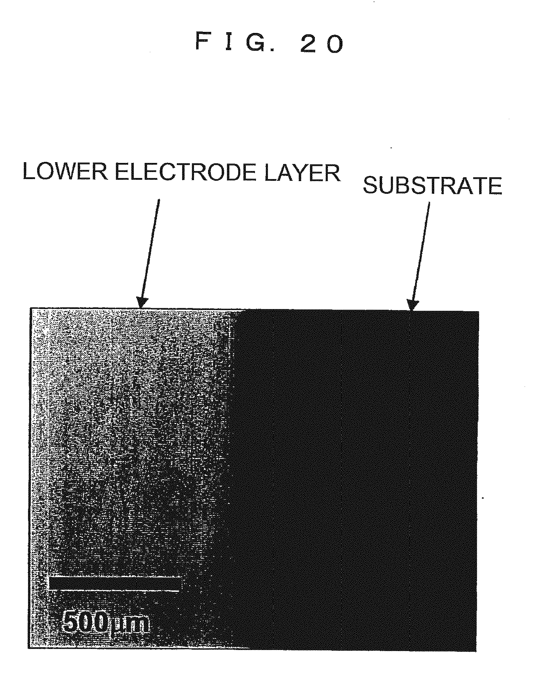

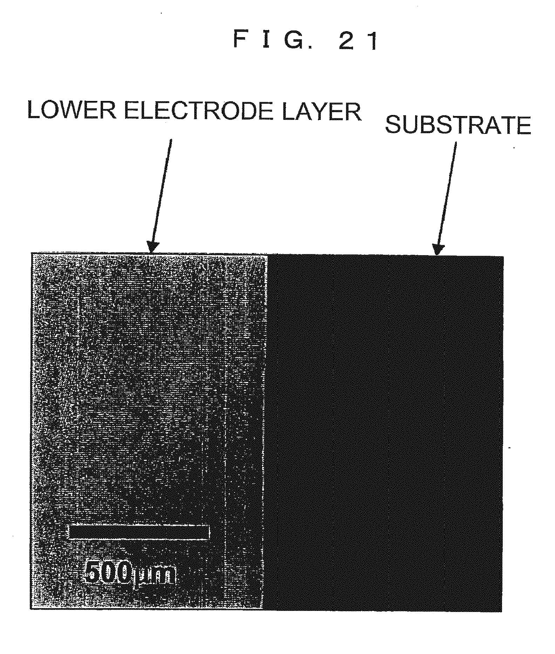

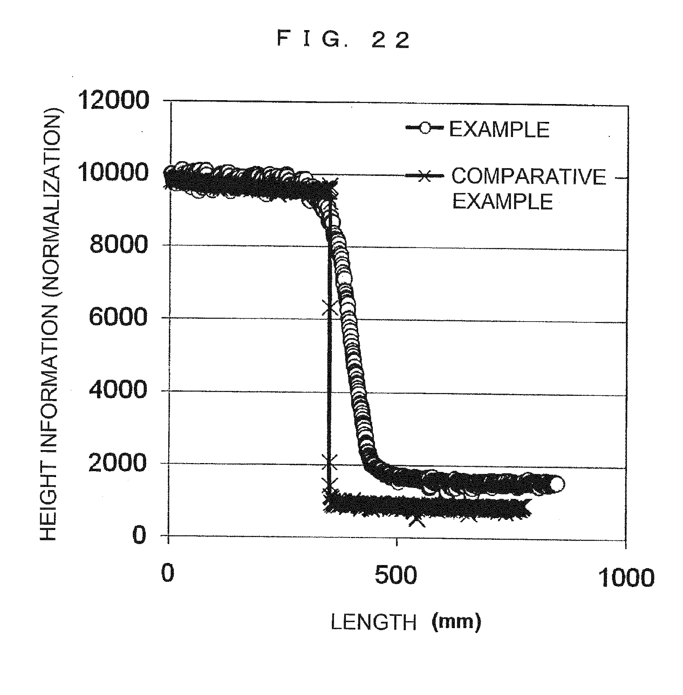

Further, as shown in FIG. 20 and FIG. 21, a planar image of the boundary portion between the substrate and the anode layer formed over the substrate was obtained for each of Example 1 and Comparative Example, using a laser microscope (VK-9700, manufactured by KEYENCE CORPORATION). Then, each image was compared with the other. Further, as shown in FIG. 22, a graph was plotted from the cross sectional profile of pattern edge of the anode layer in each of Example 1 and Comparative Example, and comparison was performed.

In Example 1, while the shielding portion of the shielding unit was arranged at the shield position that was distant from the substrate, the anode layer was formed by deposition of the vaporized material from the evaporation source onto the substrate. On the other hand, in Comparative Example, shielding was performed while the shadow mask was held in contact with the substrate, and the anode layer was formed by deposition of the vaporized material from the evaporation source onto the substrate.

As shown in FIG. 22, the pattern edge of the anode layer of Comparative Example had a side surface formed linearly, substantially along the vertical direction. In contrast, the pattern edge of the anode layer of Example 1 had a side surface formed into a curve at an angle from the vertical direction.

With this regard, referring further to FIG. 21, the boundary between the substrate and the anode layer shows up clearly on the color line in the planar image of Comparative Example, because the side surface of the anode layer was formed almost vertically, as mentioned above. In contrast, in the planar image of Example 1 (FIG. 20), the boundary between the substrate and the anode layer is unclear, which seems slightly blurred, because the side surface of the anode layer was formed at an angle.

It is understood from the above description that, in Comparative Example, deposition of the vaporized material was performed for the anode layer with the shadow mask being held in contact with the substrate, resulting in a very sharpened pattern edge of the anode layer (shown in FIG. 21 and FIG. 22). In such Comparative Example, a so-called edge leakage is likely to occur, which is not preferable. This fact has demonstrated that the method and the apparatus for manufacturing an organic EL device according to Example 1 exert a remarkable effect in preventing the occurrence of edge leakage by performing deposition with the shielding portion maintained at a distance from the substrate when forming the anode layer over the substrate.

### REFERENCE SIGNS LIST

- 1:: Vacuum chamber
- 2:: Transporting unit
- 3:: Evaporation source
- 4:: Shielding unit
- 5:: Moving unit
- 8:: Organic EL device
- 41:: Shielding portion
- 42:: Switching mechanism
- 81:: Substrate
- 82:: Lower electrode layer
- 83:: Organic layer
- 84:: Upper electrode layer
- X:: Transportation direction

## Claims

1. A method for manufacturing an organic EL device, comprising the steps of:
transporting a substrate having a strip shape so that the substrate is transported along a predetermined transportation direction;
depositing a vaporized material onto a predetermined part of the substrate by discharging the vaporized material from an evaporation source; and
arranging a shielding portion for shielding the substrate between the evaporation source and the substrate so as to prevent the deposition of the vaporized material onto a part other than the predetermined part during the deposition of the vaporized material,
wherein the shielding portion is switchable between a shield position where the shielding portion is arranged between the evaporation source and the substrate so as to shield the substrate and a shield release position where the shielding portion is withdrawn from between the evaporation source and the substrate so as to release the shielding of the substrate, and
wherein the shielding portion is moved in the predetermined transportation direction at the same speed as the substrate when the shielding portion is located at the shield position, whereas the shielding portion is moved in a direction opposite to the predetermined transportation direction when the shielding portion is located at the shield release position.

2. The method for manufacturing an organic EL device according to claim 1, wherein
the shielding portion has a larger dimension than a width dimension of the substrate so as to be arranged across a width direction of the substrate when being located at the shield position.

3. The method for manufacturing an organic EL device according to claim 1 or 2, wherein
the shielding portion is a flip-type shield plate.

4. An apparatus for manufacturing an organic EL device, comprising:
a transporting unit for transporting a substrate having a strip shape along a predetermined transportation direction;
an evaporation source for discharging a vaporized material toward a predetermined part of the substrate so that the vaporized material is deposited onto the substrate; and
a shielding unit including a shielding portion for shielding the substrate so as to prevent the deposition of the vaporized material onto a part other than the predetermined part; and
a moving unit for moving the shielding portion,
wherein the shielding unit includes a switching mechanism capable of switching the shielding portion between a shield position where the shielding portion is arranged between the evaporation source and the substrate so as to shield the substrate and a shield release position where the shielding portion is withdrawn from between the evaporation source and the substrate so as to release the shielding of the substrate, and
wherein the moving unit moves the shielding portion in the predetermined transportation direction at the same speed as the substrate when the shielding portion is located at the shield position, whereas the moving unit moves the shielding portion in a direction opposite to the predetermined transportation direction when the shielding portion is located at the shield release position.
